Europäisches Patentamt

European Patent Office

Office européen des brevets

(19)

(11) **EP 1 097 509 B1**

(12) **FASCICULE DE BREVET EUROPEEN**

(45) Date de publication et mention
de la délivrance du brevet:
**08.05.2002 Bulletin 2002/19**

(51) Int Cl.⁷: **H03C 1/60**

(21) Numéro de dépôt: **99929440.8**

(22) Date de dépôt: **08.07.1999**

(86) Numéro de dépôt international:
**PCT/FR99/01660**

(87) Numéro de publication internationale:
**WO 00/03475 (20.01.2000 Gazette 2000/03)**

(54) **MODULATEUR VECTORIEL**

VEKTORMODULATOR

VECTORIAL MODULATOR

(84) Etats contractants désignés:
**AT BE CH CY DE DK ES FI FR GB GR IE IT LI LU
MC NL PT SE**

(30) Priorité: **10.07.1998 FR 9808918**

(43) Date de publication de la demande:
**09.05.2001 Bulletin 2001/19**

(73) Titulaire: **Commisariat à l'énergie Atomique
75015 Paris 15ème (FR)**

(72) Inventeurs:
• **RUSSAT, Jean
F-91860 Epinay sous Senart (FR)**

• **FEL, Nicolas
F-94700 Maisons Alfort (FR)**

(74) Mandataire: **Des Termes, Monique
Société Brevatome
3, rue du Docteur Lancereaux
75008 Paris (FR)**

(56) Documents cités:
**GB-A- 2 064 246          GB-A- 2 240 890
US-A- 3 411 110          US-A- 5 631 610**

• **P. HAWKER: "TECHNICAL TOPICS" RADIO
COMMUNICATION, décembre 1973 (1973-12),
pages 852-857, XP002097316**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

## Description

<u>Domaine technique</u>

La présente invention concerne un modulateur vectoriel.

<u>Etat de la technique antérieure</u>

Le déphasage d'un signal électrique peut être numérique, avec des sauts de phase, soit analogique, avec variation continue en phase.

Les déphaseurs numériques emploient des diodes PIN ou des transistors à effet de champ, utilisés comme commutateurs électroniques, permettant la commutation entre lignes de transmission de différentes longueurs (déphasage par délai de propagation/transmission) ou bien entre sections de structures de filtrage du type passe-bas/passe-haut, par exemple.

L'utilisation de diodes à capacité variable (varactor) ou de transistors à effet de champ en tant qu'impédances continûment variables permet la réalisation des déphaseurs analogiques, assurant le déphasage de l'onde en transmission, comme dans les modulateurs vectoriels, ou bien en réflexion, comme dans les déphaseurs à diode.

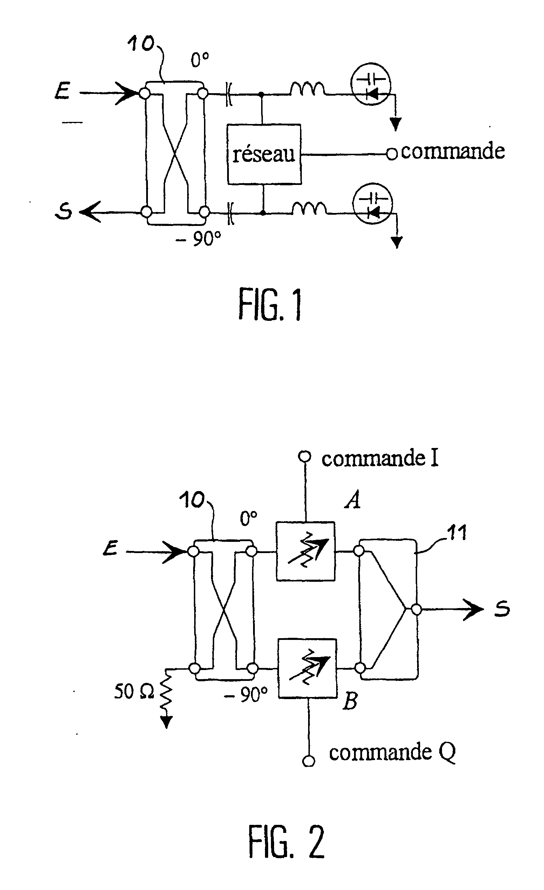

Dans un déphaseur à diodes, comme représenté sur la figure 1, les sorties en phase et en quadrature du coupleur hybride 10 sont chargées par des éléments réactifs variables. La variation d'impédance réactive par rapport à l'impédance caractéristique (50 $\Omega$ généralement) entraîne une variation de la phase du signal de sorties S par le biais d'un coefficient de réflexion complexe $\widetilde{\Gamma}$.

On obtient les signaux suivants :

- Entrée : sin($\omega$t)
- Sortie O : $\widetilde{\Gamma}$sin($\omega$t)
- Sortie -90° : - $\widetilde{\Gamma}$cos($\omega$t)
- Sortie S : - $\widetilde{\Gamma}$cos($\omega$t) = | $\widetilde{\Gamma}$|sin($\omega$t+$\varphi$), avec

$$\tan\left(\frac{\varphi}{2}\right) = \frac{1-\Gamma}{1+\Gamma}$$

Les déphaseurs à diodes utilisent essentiellement des diodes à capacité variable commandées en tension pour un déphasage continu, ou des diodes PIN fonctionnant en commutation, pour un déphasage numérique.

Dans le principe, on peut utiliser indifféremment des coupleurs hybrides en anneau ou en carré ou des transformateurs. La bande passante des déphaseurs ainsi constitués est limitée par l'emploi d'un coupleur : ces dispositifs sont typiquement à bande étroite, ou fonctionnent au mieux sur une bande de deux octaves : $\omega \rightarrow 4\omega$.

Les modulateurs vectoriels utilisent le principe d'addition de vecteurs orthogonaux (vecteurs I/Q) d'amplituàe variable.

Dans un déphaseur à modulateur vectoriel, le déphasage entre le signal d'entrée E et le signal de sortie S résulte de la recombinaison (11) de deux composantes en quadrature atténuées séparément. Un exemple de déphaseur 0-90° à modulateur vectoriel est donné sur la figure 2, avec des commandes I et Q.

Le bilan des signaux pris aux différents points du déphaseur est le suivant :

- Entrée E : sin($\omega$t)
- Sortie 0° : sin($\omega$t)/$\sqrt{2}$
- Sortie -90° : sin($\omega$t-$\pi$/2)/$\sqrt{2}$= -cos($\omega$t)/$\sqrt{2}$
- Point A : asin($\omega$t)/$\sqrt{2}$
- Point B : -bcos($\omega$t)/$\sqrt{2}$
- Sortie S : [asin($\omega$t)+ bcos ($\omega$t) ]/$\sqrt{2}$ = cos($\omega$t+$\varphi$)

    si a=cos$\varphi$ et b=sin$\varphi$

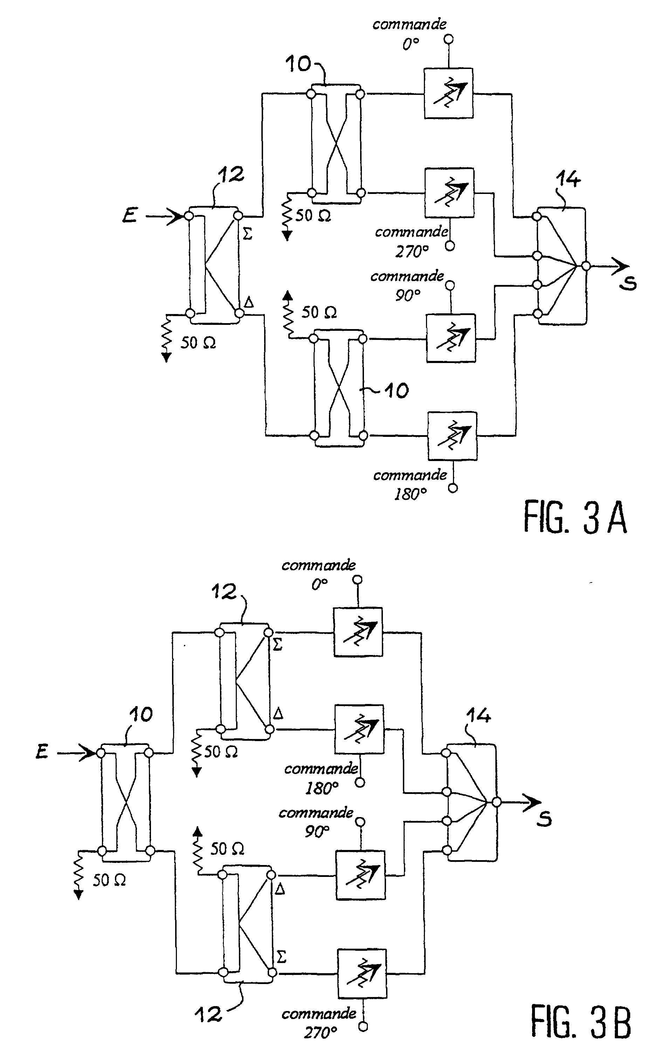

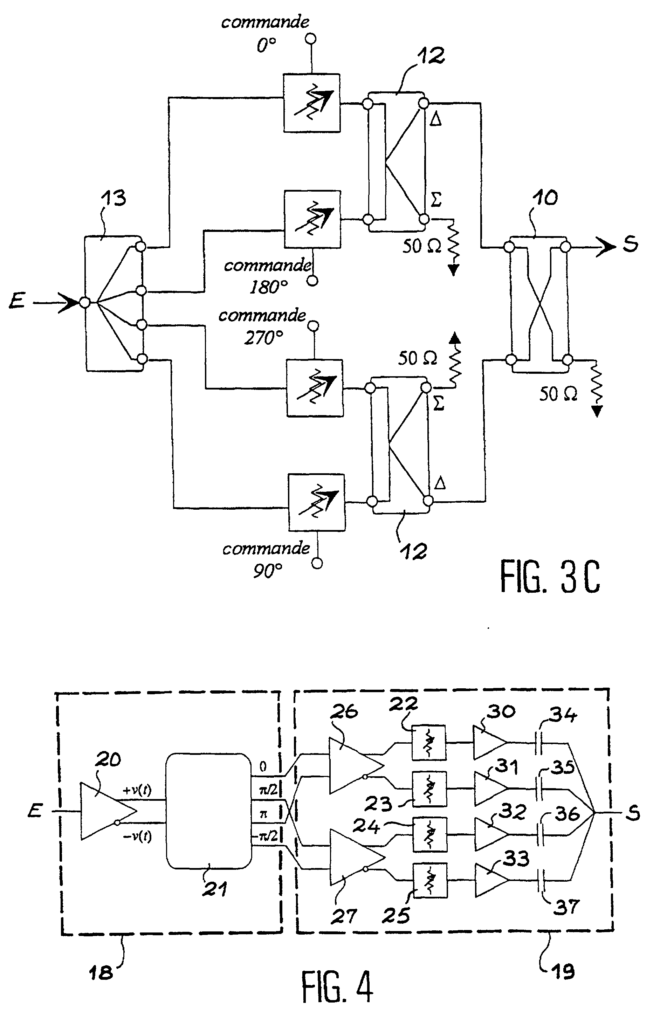

Ces dispositifs assurant le déphasage sur un quadrant, un déphaseur 0-360° s'obtient par combinaison de coupleurs hybrides 90° 10 et de coupleurs hybrides 180° 12, comme illustré sur les figures 3A, 3B ou 3C, ou bien par la mise en cascade de quatre cellules 0-90°. Le circuit référencé 13 est un diviseur 1/4 en phase et les circuits référencés 14 sont des combineurs 4: 1 en phase.

Ces différents déphaseurs sont tous basés sur la génération de signaux en quadrature de phase, par l'emploi et la combinaison de coupleurs hybrides à 90°. Par principe, les coupleurs hybrides à 90° possèdent une bande passante s'étendant au maximum à environ deux octaves. Il en est donc de même pour les déphaseurs ainsi constitués.

L'article référence [1] en fin de description décrit des structures de ce type et notamment celle d'un modulateur vectoriel.

Le document référencé [6] décrit un modulateur à bande latérale unique qui utilise un réseau filtre polyphase dans lequel les valeurs de résistance sont constituées par des condensateurs commutés équivalents.

Le document référencé [7] décrit un modulateur de porteuse supprimée à bande latérale unique comprenant un réseau de résistances parallèles et de commutateurs parallèles connectés ensemble pour laisser passer de manière sélective et pour sommer de manière variable plusieurs signaux.

L'objet de l'invention est de pallier les inconvénients des dispositifs de l'art antérieur en proposant un nouveau type de modulateur vectoriel.

<u>Exposé de l'invention</u>

La présente invention concerne un déphaseur analogique à modulateur vectoriel, comprenant :

- un étage d'entrée assurant la génération d'une pseudo-base de quatre vecteurs {±I, ±Q}, et comportant un filtre polyphasé ;

- un étage de sortie permettant la gestion de l'amplitude des vecteurs de base, ainsi que leur recombinaison,

dans lequel l'étage d'entrée comporte successivement :

- un générateur de signaux en opposition de phase ;
- un filtre ou réseau polyphasé,

caractérisé en ce que l'étape de sortie comporte :

- quatre atténuateurs variables permettant de réaliser un contrôle distinct de l'amplitude de chacun des vecteurs de base ;
- une sortie commune assurant la sommation des quatre voies en quadrature.

Avantageusement l'étage de sortie comprend deux amplificateurs différentiels isolant les atténuateurs variables du filtre/réseau polyphasé. Les voies en quadrature sont reliées à la sortie commune au travers d'étages amplificateurs tampons suivis chacun d'une capacité de sommation.

Les applications possibles pour ce type de modulateur vectoriel sont variées :

- formation de faisceaux (réseaux d'antennes, radars à antenne ou ouverture synthétique...) ;
- communications à haut débit, multiplexage fréquentiel et angulaire (communications satellite, télévision numérique, standard WDM (voir documents référencés [2] et [3] en fin de description)..) ;
- instrumentation (corrélateur, discriminateur de phase, analyseur vectoriel...).

Un tel modulateur peut être utilisé, en effet, pour la transmission de signaux en bande latérale unique (Single Side-Band ou SSB), voire en bande latérale unique sans porteuse. De tels modes de transmission conviennent aux communications satellites, télévision numérique, ou téléphonie. Le principe consiste à transposer la fréquence du signal utile pour coder un porteuse, afin de répondre à des critères d'encombrement du spectre électromagnétique ou de qualité de transmission. Il peut également être utilisé dans les réseaux d'antennes ou radars à ouverture synthétique : balayage de faisceau par balayage en phase.

Dans le cas de la télévision numérique, 11 y a deux codages successifs : codage de l'image vidéo, puis modulation sur porteuse vers 12 Ghz... En extrapolant une telle réalisation, on peut ainsi envisager une réalisation analogue en optique : d'où le modulation WDM.

Or les applications, fonctions ou systèmes qui exploitent des signaux en quadrature de phase dans une très large bande de fréquence (corrélateur, analyseur de réseaux, discriminateur de phase...) sont particulièrement attractives.

Brève description des dessins

- La figure 1 illustre un déphaseur 0 à 90° à diodes varicap de l'art antérieur ;
- la figure 2 illustre un déphaseur 0 à 90° à modulateur vectoriel de l'art antérieur ;
- les figures 3A, 3B et 3C illustrent des déphaseurs 0 à 360° par modulateur vectoriel de l'art antérieur ;
- la figure 4 illustre le modulateur vectoriel selon l'invention ;
- les figures 5A et 5B illustrent respectivement une structure de réseau polyphasé à n sections, et l'écart de quadrature entre les vecteurs I/Q en fonction de la fréquence réduite $f \times 2\pi RC$ pour n variant de 1 à 5 sections ;
- les figures 6A et 6B illustrent respectivement la fonction de transfert S21 de quatre vecteurs de base +I, -I, +Q et -Q, et l'erreur de phase par rapport à une quadrature parfaite entre les vecteurs I et ±Q, ainsi qu'une parfaite opposition de phase entre les vecteurs +I et -I, obtenues sur un modulateur vectoriel comportant un filtre polyphasé à quatre sections.

Exposé détaillé de modes de réalisation

La présente invention repose sur le principe d'un modulateur vectoriel à filtre polyphasé, comme illustré sur la figure 4.

Ce modulateur comporte :

- un étage d'entrée 18 assurant la génération d'une pseudo-base de quatre vecteurs {±I, ±Q} ;
- et un étage de sortie 19 permettant la gestion de l'amplitude des vecteurs de base, ainsi que leur combinaison.

L'étage d'entrée 18 comporte successivement :

- un générateur 20 de signaux +v(t) et -v(t) en opposition de phase, qui peut être tout dispositif fournissant deux signaux déphasés de 180° : transformateur, coupleur hybride 180°. Une solution avantageuse utilise un amplificateur différentiel à un ou plusieurs étages, pour sa grande bande passante ainsi que pour la précision d'obtention des signaux déphasés de 180° ;
- un filtre ou réseau polyphasé 21.

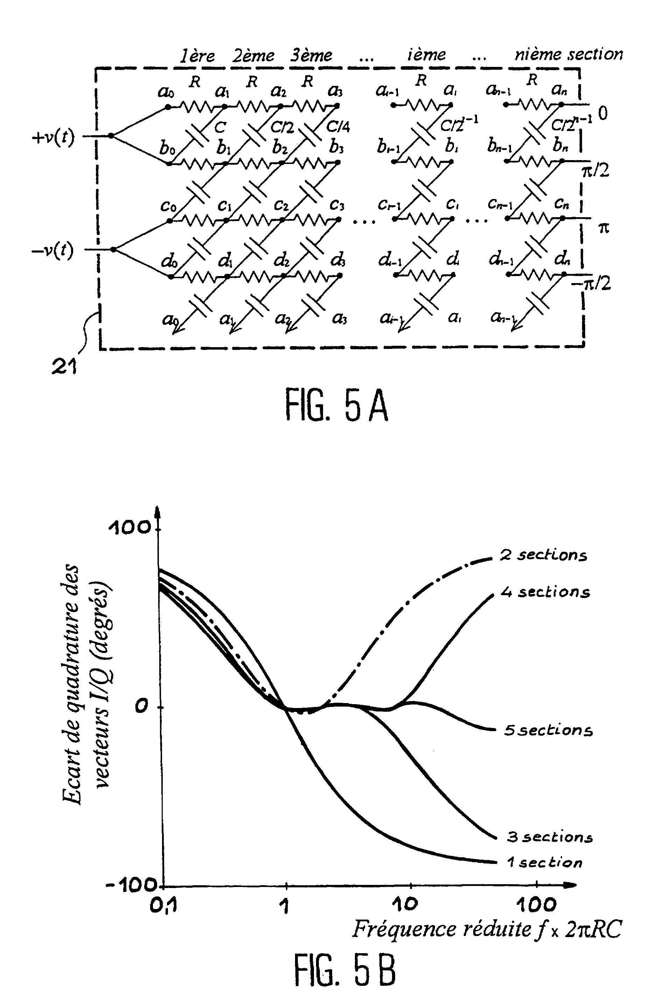

La structure de filtre/réseau polyphasé, décrite dans les documents référencés [4] et [5], est employée dans le domaine des audio-fréquences ($\sim$300 - 3000 Hz), pour la réalisation de modulateurs à bande latérale unique. Elle consiste préférentiellement en une structure cyclique et répétitive à base de résistances égales (R) et de capacités (C, C/2.... $C/2^{i-1}$, ... $C/2^{n-1}$) décroissant géométriquement, comme illustré sur la figure 5A.

La sortie du filtre/réseau polyphasé 21 délivre une pseudo-base de quatre vecteurs orthogonaux deux à deux ($\pm$1, $\pm$Q}.

La réponse en fréquence du filtre/réseau polyphasé 21 peut être décrite par une fréquence caractéristique qui représente la fréquence basse d'utilisation : $f_0 = 1/2\pi RC$.

La bande passante pour une erreur de quadrature $\delta\theta$ donnée s'accroît avec le nombre de sections.

La figure 5B représente l'écart de quadrature entre les vecteurs I et Q en fonction de la fréquence réduite f $\times$ 2$\pi$RC pour n variant de 1 à 5 sections.

L'étage de sortie 19 comporte :

- quatre atténuateurs variables 22, 23, 24 et 25 permettant de réaliser un contrôle distinct de l'amplitude de chacun des vecteurs de base ; avantageusement ces atténuateurs 22, 23, 24 et 25 peuvent être isolés du filtre/réseau polyphasé 21 par deux amplificateurs différentiels 26 et 27, afin de minimiser l'influence des variations de charge sur le comportement global du modulateur ;
- une sortie commune S assurant la sommation des quatre voies en quadrature ; ces quatre voies en quadrature peuvent ainsi être reliées au port commun de sortie S au travers d'étages amplificateurs tampons 30, 31, 32 et 33 suivis des capacités de sommation 34, 35, 36 et 37.

L'étage de sortie 19 peut comporter indifféremment toute structure permettant de modifier séparément l'amplitude des vecteurs de base (mélangeurs, amplificateurs à gain variable par exemple).

La figure 6A représente la fonction de transfert S21 lorsque chacun des quatre vecteurs de base +I, -I, +Q et -Q est successivement sélectionné. La mesure est effectuée entre 10 MHz et 3000 MHz. La bande passante à -3 dB de chacun de ces vecteurs est de l'ordre de 30 Mhz - 1500 Mhz (soit un rapport de 50 à 1), qui est aussi la bande passante du modulateur vectoriel. Sa bande de fonctionnement pour une erreur de phase donnée (par exemple $\pm$ 5°) est légèrement inférieure ($\sim$ 80 MHz - 1300 MHz à $\pm$ 5°).

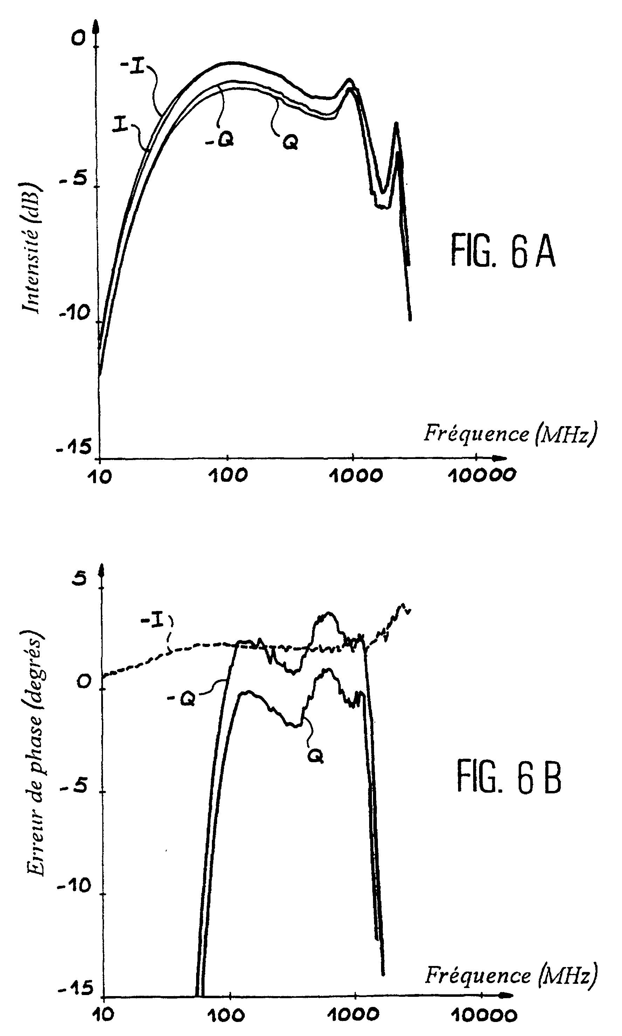

La figure 6B illustre l'erreur de phase par rapport à une quadrature parfaite entre I et $\pm$Q, ainsi qu'à une parfaite opposition de phase entre I et -I.

REFERENCES

[1] « Microwave Components and Subsystems » (Anaren, Proven Performance In Signal Processing, pages 108-115 et 125-129)

[2] « Advanced Technologies Pave The Way For Photonic Switches » de Rod C. Alferness (Laser Focus World, février 1995, pages 109 à 113)

[3] « Wavelength-Division Multiplexing Technology In Photonic Switching » de Masahiko Fujiwara et Shuji Suzuki (« Photonic Switching and Interconnects » de Abdellatif Marrakchi, Marcel Dekker, Inc., pages 77-113)

[4] « The Art Of Electronics » de Paul Horowitz et Winfield Hill (Cambridge University Press, Seconde Edition, 1989, chapitre. 5 : « Filtres actifs et oscillateurs », figure 5.41)

[5] « Radio Amateur's Handbook » de Frederick Collins et Robert Hertzberg (15ème éd. rev., 1983, pages 12-8 et 12-9)

[6] GB-A-2 064 246

[7] US-A-3 411 110

## Revendications

**1.** Déphaseur analogique à modulateur vectoriel, comprenant :

- un étage d'entrée (18), assurant la génération d'une pseudo-base de quatre vecteurs {$\pm$I, $\pm$Q}, et comportant un filtre polyphasé (21) ;
- un étage de sortie (19) permettant la gestion de l'amplitude des vecteurs de base, ainsi que leur recombinaison ;

dans lequel l'étage d'entrée (18) comporte successivement :

- un générateur de signaux en opposition de phase (20) ;
- un filtre polyphasé (21) ;

**caractérisé en ce que** l'étage de sortie (19) comporte :

- quatre atténuateurs variables (22, 23, 24, 25) permettant de réaliser un contrôle distinct de l'amplitude de chacun des vecteurs de base ;
- une sortie commune (S) assurant la sommation des quatre voies en quadrature.

**2.** Déphaseur selon la revendication 1, dans lequel l'étage de sortie comprend deux amplificateurs différentiels (26, 27) isolant les atténuateurs variables (22, 23, 24, 25) du filtre polyphasé (21).

**3.** Déphaseur selon la revendication 1, dans lequel les voies en quadrature sont reliées à la sortie commune (S) au travers d'étages amplificateurs tampons (30, 31, 32, 33), suivis chacun d'une capacité de sommation (34, 35, 36, 37).

## Patentansprüche

1. Phasenschieber mit Vektormodulator, umfassend:

   - eine Eingangsstufe (18), die eine Pseudobasis von vier Vektoren (±I, ±Q) erzeugt und ein Vielphasenfilter (21) umfasst;
   - eine Ausgangsstufe (19), die die Steuerung der Amplitude der Basisvektoren sowie ihre Rekombination ermöglicht;

   bei dem die Eingangsstufe (18) nacheinander umfasst:

   - einen gegenphasigen Signalgenerator (20);
   - ein Vielphasenfilter (21);

   **dadurch gekennzeichnet,**
   **dass** die Ausgangsstufe (19) umfasst:

   - vier variable Dämpfungs- bzw. Schwächungsglieder (22, 23, 24, 25), um eine unterschiedliche Kontrolle der Amplitude jedes der Basisvektoren zu ermöglichen;
   - einen gemeinsamen Ausgang (S), der die Summierung der vier um 90° phasenverschobenen Kanäle gewährleistet.

2. Phasenschieber nach Anspruch 1, bei dem die Ausgangsstufe zwei Differentialverstärker (26, 27) umfasst, die die variablen Dämpfungs- bzw. Schwächungsglieder (22, 23, 24, 25) von dem Polyphasenfilter (21) isolieren.

3. Phasenschieber nach Anspruch 1, bei dem die um 90° phasenverschobenen Kanäle durch Pufferverstärkerstufen (30, 31, 32, 33), jede gefolgt von einer Summierkapazität (34, 35, 36, 37), mit dem gemeinsamen Ausgang (S) verbunden sind.

## Claims

1. Analogue phase shifter with vector modulator comprising:

   - an input stage (18), providing the generation of a pseudo-basis of four vectors (±I, ±Q), and including a multiphase filter (21);
   - an output stage (19), making it possible to control the amplitude of the basis vectors, and to recombine them;

   wherein the input stage (18) includes successively:

   - a phase opposition signal generator (20);
   - a multiphase filter (21);

   **characterized in that** the output stage (19) includes:

   - four variable attenuators (22, 23, 24, 25) making it possible to achieve separate control of the amplitude of each of the basis vectors;
   - a common output (S) ensuring the summation of the four quadrature channels.

2. Phase shifter according to claim 1, wherein the output stage comprises two differential amplifiers (26, 27) isolating the variable attenuators (22, 23, 24, 25) from the multiphase filter (21).

3. Phase shifter according to claim 1, wherein the quadrature channels are connected to the common output (S) through buffer amplifier stages (30, 31, 32, 33), each followed by a summation capacitor (34, 35, 36, 37).

FIG. 1

FIG. 2

FIG. 3 A

FIG. 3 B

commande
0°

12

13

commande
180°

commande
270°

50 Ω

Σ

10

E

50 Ω

Σ

S

Δ

50 Ω

12

commande
90°

**FIG. 3 C**

20

+v(t)

26

22

30

34

E

21

0

π/2

π

-π/2

23

31

35

27

24

32

36

S

25

33

37

18

19

**FIG. 4**

-v(t)

FIG. 5 A

FIG. 5 B

FIG. 6 A

FIG. 6 B